# EUROPEAN PATENT SPECIFICATION

(11) **EP 2 791 574 B1**
(45) Date of publication and mention of the grant of the patent: **18.05.2016**
(21) Application number: 12813513.4
(22) Date of filing: 04.12.2012
(51) Int. Cl.: F21K 99/00, F21S 8/02, F21V 9/16, F21V 13/02, F21V 13/08, H01L 25/075, H01L 33/50, F21Y 115/10

(54) **OPTICAL ARRANGEMENT WITH DIFFRACTIVE OPTICS**
OPTISCHE ANORDNUNG MIT DIFFRAKTIVER OPTIK
AGENCEMENT OPTIQUE AYANT DES OPTIQUES DIFFRACTANTES

(30) Priority: 16.12.2011 US 201161576398 P
(43) Date of publication of application: 22.10.2014
(73) Proprietor: Koninklijke Philips N.V., 5656 AE Eindhoven (NL)
(72) Inventor: HIKMET, Rifat, Ata, Mustafa, NL-5656 AE Eindhoven (NL); VAN BOMMEL, Ties, NL-5656 AE Eindhoven (NL)
(74) Representative: van Eeuwijk, Alexander Henricus Waltherus
(86) International application number: PCT/IB2012/056932
(87) International publication number: WO 2013/088296

(56) References cited:
- CN-A- 1 693 968
- CN-A- 101 936 475
- DE-A1- 10 164 033
- US-A1- 2010 085 727

## Description

### FIELD OF THE INVENTION

The present invention relates to an optical arrangement, and especially to an optical arrangement comprising a diffractive member.

### BACKGROUND OF THE INVENTION

Optical arrangements may comprise a plurality of light sources which emit light arranged to pass through a layer of luminescent material on its way out from the optical arrangement. When the light from a light source reaches the luminescent layer, a part of the light will be reflected back towards the light source. There is a need of providing optical arrangements in a compact design, i.e. with a short distance between the light source and the luminescent layer. With a short distance between the light source and the luminescent layer, the light reflected back towards the light source will hit the light source and be absorbed by the material in the light source. This causes a decreased efficiency of the optical arrangement due to lost light.

One way to alleviate this drawback is to configure the luminescent layer to decrease the amount of light that is reflected back towards the light source, e.g. as disclosed in WO2010/151055 wherein an optical arrangement is provided with optical structures in a top layer of the arrangement, through which layer the light from a light source passes. The optical structures are arranged to avoid light being reflected back towards the light source. The optical structures are provided at a rear surface of the layer, which rear surface faces the light source. Light that is reflected at a front surface of the layer back inside the layer, is then once again, by means of the optical structures, reflected at the rear surface to avoid light going back inside the optical arrangement. However, such layer with optical structures in a top layer is complicated and costly to manufacture, and further provides a trade-off between reflection optimization and the size of the optical arrangement.

Consequently, there is a need for an optical arrangement of compact size which alleviates the drawback of reflected light being absorbed by the light source.

### SUMMARY OF THE INVENTION

It is an object of the present invention to at least partly overcome this problem and to provide an optical arrangement with high light-emitting efficiency and of compact size. The invention is defined by the claims.

According to a first aspect of the invention, this object is achieved by an optical arrangement, comprising an optical chamber comprising a light exit window, wherein the chamber is defined by a bottom and at least one surrounding wall, and wherein a surface of the bottom of the chamber is reflective. At least one light source is arranged at the bottom of the chamber and adapted to emit light towards the light exit window. The light exit window of the chamber comprises a luminescent member comprising multiple phosphor layers or multiple phosphor segments. The optical arrangement further comprises a diffractive member arranged between the light source and the light exit window, such that light emitted from the light source towards the light exit window layer is adapted to pass through the diffractive member.

By providing a diffractive member between the light source and the light exit window, the light emitted by the light source may be spread towards a portion of the luminescent member not directly above the light source. This may lead to light being reflected from the luminescent member back into the chamber does not hit the light source but the bottom of the chamber. Since the bottom surface of the chamber may be adapted to reflect light, the reflected light from the luminescent member may again be reflected from the bottom surface of the chamber, back towards the luminescent member, where it eventually may be emitted from the optical arrangement. The light-emitting efficiency of the optical arrangement may thereby be greatly increased. Further, by diffracting the light from the light source, and achieving a re-reflection of light reflected from the luminescent member, a more homogenous light output from the optical arrangement via the light exit window may be achieved.

It is noted that the published Chinese patent application CN 1693968A discloses a light system with red, green and blue emitting LEDs that are positioned in an optical chamber. The light exits the optical chamber via a light exit window. The optical chamber further has a diffracting layer for providing a more uniform light output In one embodiment, the optical arrangement may comprise a plurality of light sources. A plurality of light sources may provide a desired light output from the optical arrangement.

In a further embodiment, at least two light sources may share a common diffractive member. That is, a single diffractive member may be arranged to receive light emitted by at least two different light sources.

A plurality of light sources may be arranged next to each other. They may thereby share a common diffractive member. This may facilitate a manufacturing process of the optical arrangement. The light sources may be arranged at a relatively small area of the bottom of the chamber. The light from the light sources may thereby be directed by the diffractive member towards portions of the luminescent member above the rest of the chamber bottom.

In another embodiment, said surrounding wall of the chamber may be reflective.

The light from the light source may be diffracted by the diffractive member towards the surrounding wall of the chamber. Due to the reflectivity of the surfaces of the surrounding wall and the bottom of the chamber, the light diffracted towards the surrounding wall may be reflected towards the luminescent member.

In one embodiment, said at least one light source and diffractive member may be arranged at a portion of the bottom of the chamber near said surrounding wall.

The light from the light sources may thereby be diffracted by the diffractive member towards a center portion of the luminescent member and towards the surrounding wall of the chamber. Due to the reflectivity of the surfaces of the surrounding wall and the bottom of the chamber, the light diffracted towards the surrounding wall may be reflected towards the same center portion of the luminescent member. The light emitted from the optical arrangement through the luminescent member may thereby be concentrated to the central portion of the luminescent member.

In a further embodiment, said diffractive member may be attached to said light source.

The diffractive member may be attached to the light source. All light emitted by the light source may thereby be diffracted by the diffractive member. The diffractive member may be arranged on top of the light source, with a distance to the light exit window.

In an alternative embodiment, said diffractive member may be arranged at a distance d1 from said light source.

When the light from the light source passes through the diffractive member, it may be diffracted with an angle to a direction perpendicular to the diffractive member. By arranging the diffractive member at a distance from the light source, the angle of the diffracted light may be controlled. This may affect the behavior of the light reaching the luminescent member, the amount of light being reflected back into the chamber and the light intensity at a certain portion of the luminescent member. The diffractive member may further be arranged with a distance to the light exit window.

In a further embodiment, the diffractive member may be arranged at a distance (d₂) from the luminescent member.

In order to diffract the light from the light source towards the luminescent member, the diffractive member may be arranged at a distance d2 from the luminescent member. The distance d2 may be selected with regard to the properties of the optical arrangement (in particular the light source, the diffractive member, and/or the luminescent member) and the desired light output from the optical arrangement.

In one embodiment, said light source may be a solid state light source, such as an LED or a laser diode.

An LED or a laser diode may provide a focused light emission, which may be diffracted by the diffractive member.

In one embodiment, said chamber may be filled with a fluid or solid.

The chamber may be filled with air or a substantially transparent fluid or solid. This may further be used for directing the diffracted light and to control its behavior when being reflected in the chamber. The chamber may be defined by a shell formed by the bottom surface, the surrounding wall and the light exit window. This shell, i.e. the chamber, may be filled with a fluid or solid material. Such fluid or solid may be glass, rubber, quartz, silicone or the like.

Said luminescent member comprises multiple phosphor layers or multiple phosphor segments.

A phosphor layer may be used to provide a desired light output from the optical arrangement. The phosphor layer may diffuse, scatter and/or color the light. Multiple phosphor layers or segments may be used to provide a further desired light output from the optical arrangement.

In one embodiment, said luminescent member may be a transparent layer.

The luminescent member may be an organic or an inorganic phosphor layer. With organic phosphor, the luminescent member may be transparent.

In an alternative embodiment, said luminescent member may be a scattering layer.

The luminescent member may be an organic or an inorganic phosphor layer. With inorganic phosphor, the luminescent member may scatter the light passing through. The inorganic phosphor layer may thereby be used to design the light output from the optical arrangement by scattering light in the layer. The scattering function in the luminescent member may further be used in combination with the diffractive member. The diffractive member may focus the light output to certain portions of the luminescent member. A scattering function in the luminescent member may spread the light emitted from the optical arrangement. The organic phosphor may be used in combination with light-scattering elements such as particles.

It is noted that the invention relates to all possible combinations of features recited in the claims.

### BRIEF DESCRIPTION OF THE DRAWINGS

The various aspects of the invention, including its particular features and advantages, will be readily understood from the following detailed description and the accompanying drawings, in which:
Fig. 1a is a perspective view of an optical arrangement according to an embodiment of the present invention;
Fig. 1b illustrates an optical arrangement according to an embodiment of the present invention;
Fig. 1c illustrates an optical arrangement according to an embodiment of the present invention;
Fig. 2 illustrates an optical arrangement according to an embodiment of the present invention;
Fig. 3 illustrates an optical arrangement according to an embodiment of the present invention;
Fig. 4 illustrates an optical arrangement according to an embodiment of the present invention;
Fig. 5a illustrates an optical arrangement according to an embodiment of the present invention;
Fig. 5b illustrates an optical arrangement according to an embodiment of the present invention.

### DETAILED DESCRIPTION

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness, and fully convey the scope of the invention to the skilled person. Like reference characters refer to like elements throughout.

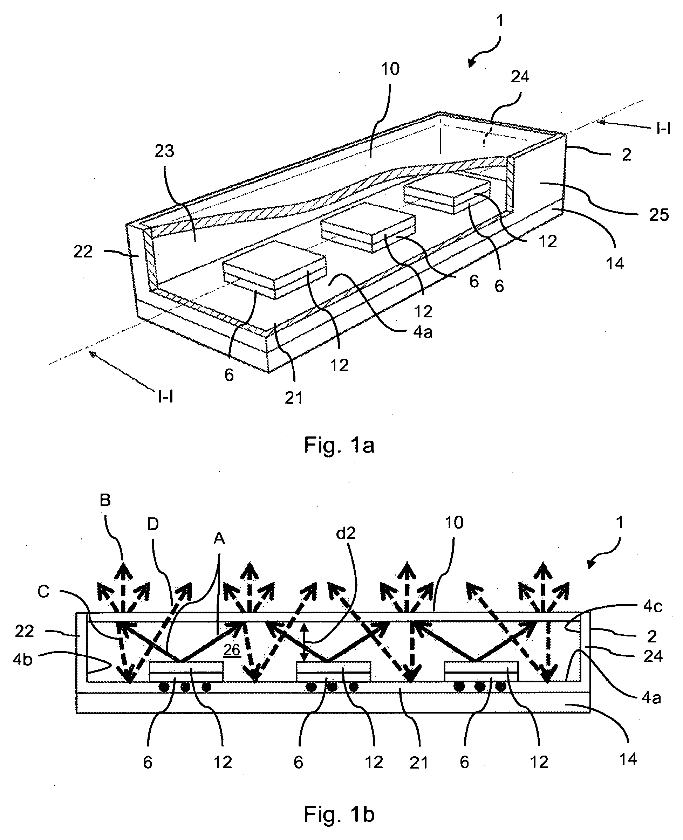

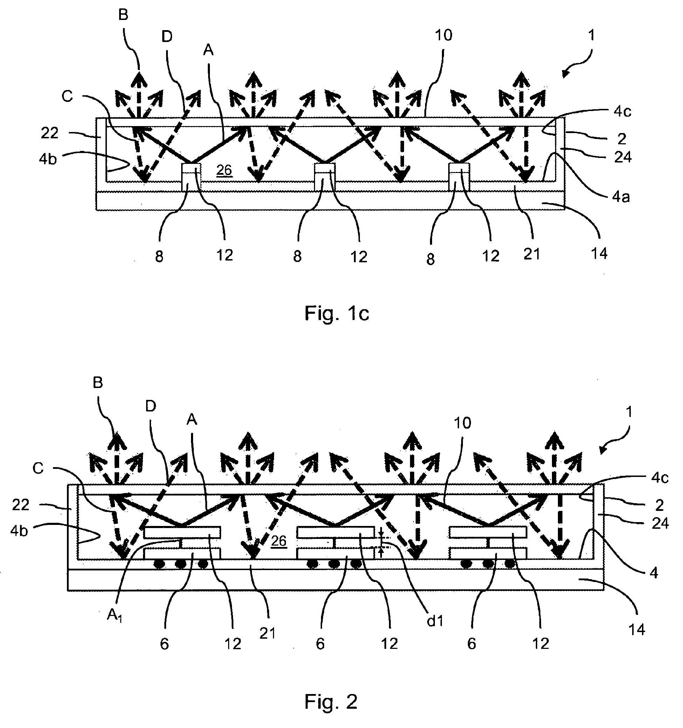

Figs. 1a-c illustrate an optical arrangement 1 according to an embodiment of the present invention. The optical arrangement 1 comprises an optical chamber 2 arranged on a base 14. The base 14 may be a substrate. The chamber 2 forms an interior space 26. The chamber 2 is defined by a bottom 21, a surrounding wall 22, 23, 24, 25 and a light exit window defined by a luminescent member 10. The surrounding wall is defined by a plurality of sides 22, 23, 24, 25. Inside the chamber 2, at the bottom 21 of the chamber 2, a plurality of light sources 6, 8 are arranged. The light sources may be light-emitting diodes (LEDs) 6 (fig. 1b) and/or laser diodes 8 (fig. 1c). The luminescent member 10 is arranged remote of the light source 6. The chamber 2 is in figs. 1b and 1c illustrated in a two-dimensional cross-section along the line I-I, not showing the sides 23, 25 forming the three-dimensional chamber 2. Inner surfaces 4a, 4b, 4c of the bottom 21 and sides 22, 24 of the chamber 2 are highly reflective. Additionally, the sides 23 and 25 have highly reflective inner surfaces. The highly reflective surfaces may be achieved by an aluminum coating on the surface.

On top of each light source 6, 8, a diffractive member 12 is arranged. The diffractive member 12 is arranged to diffract and spread light emitted by the light source 6, 8. The diffractive member 12 is arranged with a distance d2 from the luminescent member 10.

Light A is emitted from a light source 6, 8 through the above arranged diffractive member 12. Due to the diffractive member 12, the light A from the light source 6, 8 does not spread straight up towards the luminescent member 10. The light A is spread toward portions of the luminescent member 10 that are not directly aligned with a light source 6, 8, but aligned with a reflective section of the chamber bottom 21. A large portion B of the light source emitted light A passes the luminescent member 10 and is emitted from the optical arrangement 1. However, a portion C is reflected when reaching the luminescent member 10. The reflected light C is reflected back into the interior 26 of the chamber 2. Due to the spreading of the light A by means of the diffractive member 12, the reflected light C is reflected towards the bottom surface 4a of the chamber bottom 21. The light D is thereby re-reflected from the bottom surface 4a towards the luminescent member 10, and a further portion of the light A emitted by the light source 6, 8 is emitted from the optical arrangement 1.

As seen in fig. 2, the diffractive member 12 may be arranged with a distance d1 between each light source 6 and the corresponding diffractive member 12. The light A₁ emitted from the light source 6 thereby travels the distance d1 before reaching the diffractive member 12 and being spread towards the luminescent member 10. With the distance d1 between the light source 6 and the diffractive member 12, the light can be diffracted in certain angular ranges depending on the distance d1, and provide high intensity of the light emitted from certain portions of the optical arrangement 1.

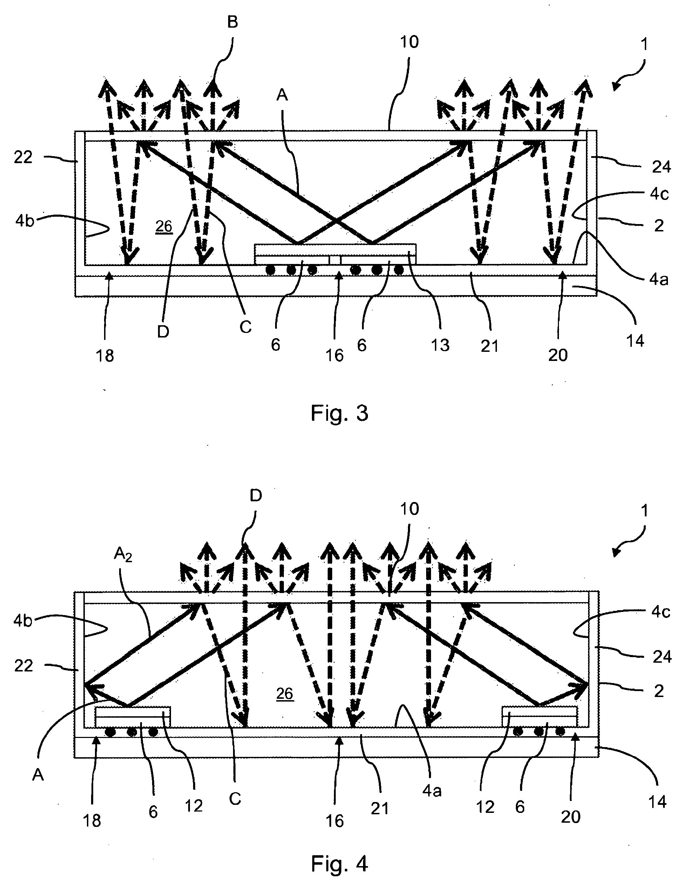

As illustrated in fig. 3, two or more light sources 6 may share a common diffractive member 13. The light sources 6 are arranged close together in a central portion 16 of the chamber bottom 21. The diffractive member 13 spreads the light A towards peripheral portions of the luminescent member 10. The reflected light C is reflected towards side portions 18, 20 of the chamber bottom 21. The properties of the light B, D emitted from the optical arrangement 1 may be configured by means of the diffractive member 13, the location of the light sources 6 and which portions of the chamber bottom 21 the reflected light C is re-reflected from.

Alternatively, as seen in fig. 4, the light sources 6 can be arranged at side portions 18, 20 of the chamber bottom 21. Each light source 6 is provided with a diffractive member 12. The side portions 18, 20 are located adjacent to the sides 22, 24 of the chamber 2. When a light source 6 with a diffractive member 12 is arranged close to a side 22, 24 of the chamber 2, light A emitted from the light source 6 is directed towards a side 22. Due to the reflectivity of the inner surface 4b of the side 22, light A₂ is reflected towards the luminescent member 10. One part B of the light reaching the luminescent member 10 is emitted from the optical arrangement 1 and one part C is reflected back into the interior 26 of the chamber 2. The reflected light C is further re-reflected D from the bottom surface 4a towards the luminescent member 10 and emitted from the optical arrangement 1. The light reflection properties in the chamber 2 is similar for light sources 6 arranged adjacent to the side 24 with its reflective inner surface 4c, or adjacent to further sides of the chamber 2 not shown. Further, light may be reflected in a similar manner from the sides 23 and 25.

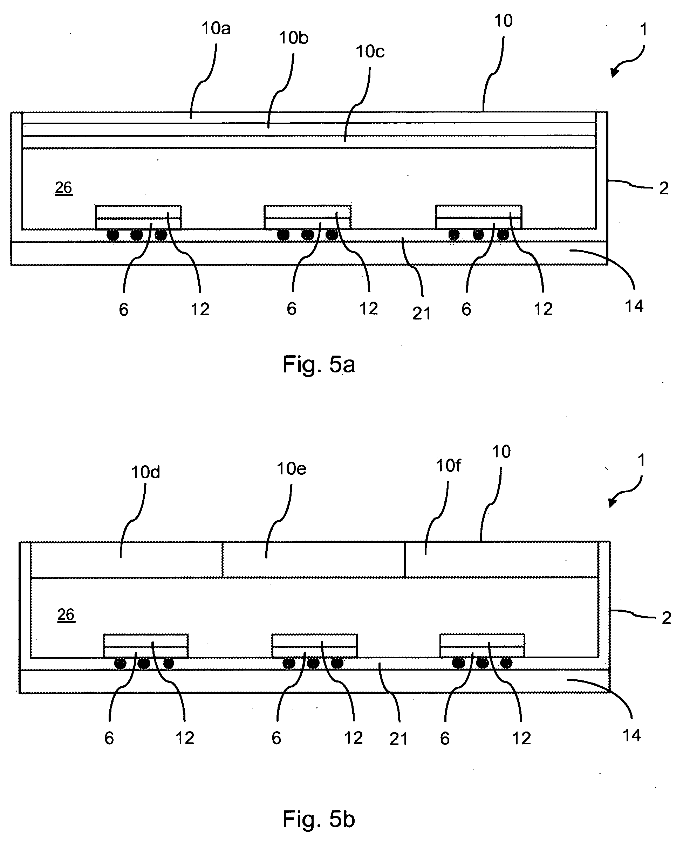

Figs. 5a and 5b illustrate two embodiments wherein the optical arrangement 1 comprises a luminescent member 10 divided into a plurality of sub-layers 10a-c or a plurality of segments 10d-f. Light sources 6 are provided on the bottom 21 of the chamber 2, with diffractive members 12 arranged on top. Light from the light sources 6 are diffracted towards the luminescent member 10. The sub-layers 10a-c of the luminescent member 10 may be designed to provide certain optical properties. This is used to achieve reflective properties of the luminescent member 10 which minimizes the reflection of light back into the chamber 2, and further facilitates light re-reflected from the bottom 21 of the chamber 2 to pass through the luminescent member 10 and be emitted from the optical arrangement 1.

The segments 10d-f in the embodiment shown in fig. 5b provides optical properties of the luminescent member 10 which is different in different portions of the luminescent member 10. In combination with the design of the diffractive members 12, the segments 10d-f may be designed to provide a desired light output emitted from the optical arrangement 1. The segments 10d-f may further be used to compensate for different behavior of the light reaching the luminescent member 10 in different portions of the optical arrangement 1, to achieve a homogenous optical output emitted from the optical arrangement 1.

The luminescent member 10 comprises a luminescent material capable of converting light of a wavelength range emitted by the light source 6 into light of a different wavelength range, typically of longer wavelengths. For example, the luminescent material may be capable of converting blue light into light of another color, such as yellow. Such luminescent material may be phosphor. In one embodiment, the luminescent material may be a plurality of luminescent materials, such as inorganic luminescent material or organic luminescent material, alone or in combination. The luminescent material may further comprise quantum dots or quantum rods. Such quantum dots or rods may be based on CdSe, CdS or InP. The luminescent material may be colored to color the light emitted from the optical arrangement. An example of an organic luminescent material is luminescent material based on perylene derivatives, which are for instance sold under the name Lumogen^{®} by BASF, which may include Lumogen^{®} Red f305, Lumogen^{®} Orange f240, Lumogen^{®} Yellow f083, Lumogen^{®} Yellow f170 etc. Examples of inorganic luminescent materials may include Ce doped YAG (Y₃Al₅O₁₂) or LuAG (Lu₃Al₅O₁₂). The Ce doped YAG emits a yellowish light, and the Ce doped LuAG emits a yellow-greenish light. Further examples of inorganic luminescent materials, which emits red light, may include ECAS (ECAS, Ca₁₋ₓAlSiN₃:Euₓ, wherein 0<x≤1, especially x≤0.2) or BSSN (BSSNE, Ba_{2-x-z}MₓSi_{5-y}Al_{y}N_{8-y}O_{y}:Eu_{z}, wherein M=Sr, Ca; 0≤x≤1, especially x≤0.2; 0≤y≤4; 0.0005≤z≤0.05).

In the illustrated embodiments, the interior space 26 of the chamber 2 may be filled with a fluid or solid material, instead of air. This may provide optical characteristics of the chamber 2 improving the diffraction and reflection of light A, C, D inside the chamber 2. Such fluid material may be e.g. oil or the like. Such solid material may be e.g. glass, rubber, quartz, silicone or the like.

The person skilled in the art realizes that the present invention by no means is limited to the preferred embodiments described above. On the contrary, many modifications and variations are possible within the scope of the appended claims. For example, the material of the luminescent member may further be selected from additional examples of materials, and the structural design of the chamber may vary, for instance by comprising a further number of light sources and diffractive members.

Additionally, variations to the disclosed embodiments can be understood and effected by the skilled person in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage.

## Claims

1. An optical arrangement (1), comprising
an optical chamber (2) comprising a light exit window, wherein the chamber is defined by a bottom (21) and at least one surrounding wall (22, 23, 24, 25), and wherein a surface (4a) of the bottom (21) of the chamber is reflective, and
at least one light source (6, 8) arranged at the bottom (21) of the chamber (2) and adapted to emit light towards the light exit window,
wherein the light exit window of the chamber comprises a luminescent member (10), and
wherein the optical arrangement further comprises a diffractive member (12, 13) arranged between the light source (6, 8) and the light exit window, such that light emitted from the light source towards the light exit window layer is adapted to pass through the diffractive member (12); **characterized in that** the luminescent member (10) comprises multiple phosphor layers (10a-c) or multiple phosphor segments (10d-f).

2. An optical arrangement according to claim 1, wherein the optical arrangement comprises a plurality of light sources (6).

3. An optical arrangement according to claim 2, wherein at least two light sources share a common diffractive member (13).

4. An optical arrangement according to claim 1, wherein said surrounding wall (22, 23, 24, 25) of the chamber (2) is reflective.

5. An optical arrangement according to claim 1, wherein said at least one light source (6, 8) and diffractive member (12, 13) are arranged at a portion of the bottom (21) of the chamber (2) near said surrounding wall.

6. An optical arrangement according to claim 1, wherein said diffractive member (12, 13) is attached to said light source (6, 8).

7. An optical arrangement according to claim 1, wherein said diffractive member (12, 13) is arranged at a distance d1 from said light source (6, 8).

8. An optical arrangement according to claim 1, wherein the diffractive member (12, 13) is arranged at a distance d2 from the luminescent member (10).

9. An optical arrangement according to claim 1, wherein said light source (6, 8) is an LED (6) or a laser diode (8).

10. An optical arrangement according to claim 1, wherein said chamber (2) is filled with a fluid or solid.

11. An optical arrangement according to claim 1, wherein said luminescent member (10) is transparent.

12. An optical arrangement according to claim 1, wherein said luminescent member (10) is scattering.

13. A luminaire comprising an optical arrangement according to any one of the claims 1 to 12.

## Patentansprüche

1. Optische Anordnung (1), umfassend:
eine optische Kammer (2) mit einem Lichtaustrittsfenster, wobei die Kammer durch eine Unterseite (21) und mindestens eine umgebende Wand (22, 23, 24, 25) definiert wird, und wobei eine Oberfläche (4a) der Unterseite (21) der Kammer reflektiv ist, sowie
mindestens eine Lichtquelle (6, 8), die auf der Unterseite (21) der Kammer (2) angeordnet und so eingerichtet ist, dass sie Licht zu dem Lichtaustrittsfenster hin abstrahlt,
wobei das Lichtaustrittsfenster der Kammer ein lumineszierendes Element (10) umfasst, und
wobei die optische Anordnung weiterhin ein diffraktives Element (12, 13) umfasst, das zwischen der Lichtquelle (6, 8) und dem Lichtaustrittsfenster so angeordnet ist, dass von der Lichtquelle zu der Lichtaustrittsfensterschicht hin abgestrahltes Licht so vorgesehen ist, dass es durch das diffraktive Element (12) hindurchgeht, **dadurch gekennzeichnet, dass** das lumineszierende Element (10) mehrere Leuchtstoffschichten (10a-c) oder mehrere Leuchtstoffsegmente (10d-f) umfasst.

2. Optische Anordnung nach Anspruch 1, wobei die optische Anordnung mehrere Lichtquellen (6) umfasst.

3. Optische Anordnung nach Anspruch 2, wobei mindestens zwei Lichtquellen sich ein gemeinsames diffraktives Element (13) teilen.

4. Optische Anordnung nach Anspruch 1, wobei die umgebende Wand (22, 23, 24, 25) der Kammer (2) reflektiv ist.

5. Optische Anordnung nach Anspruch 1, wobei die mindestens eine Lichtquelle (6, 8) und das diffraktive Element (12, 13) in einem Abschnitt der Unterseite (21) der Kammer (2) in der Nähe der umgebenden Wand angeordnet sind.

6. Optische Anordnung nach Anspruch 1, wobei das diffraktive Element (12, 13) an der Lichtquelle (6, 8) angebracht ist.

7. Optische Anordnung nach Anspruch 1, wobei das diffraktive Element (12, 13) in einem Abstand d1 von der Lichtquelle (6, 8) angeordnet ist.

8. Optische Anordnung nach Anspruch 1, wobei das diffraktive Element (12, 13) in einem Abstand d2 von dem lumineszierenden Element (10) angeordnet ist.

9. Optische Anordnung nach Anspruch 1, wobei die Lichtquelle (6, 8) eine LED (6) oder eine Laserdiode (8) ist.

10. Optische Anordnung nach Anspruch 1, wobei die Kammer (2) mit einer Flüssigkeit oder einem Festkörper gefüllt ist.

11. Optische Anordnung nach Anspruch 1, wobei das lumineszierende Element (10) transparent ist.

12. Optische Anordnung nach Anspruch 1, wobei das lumineszierende Element (10) streuend ist.

13. Leuchte mit einer optischen Anordnung nach einem der Ansprüche 1 bis 12.

## Revendications

1. Agencement optique (1), comprenant
une chambre optique (2) comprenant une fenêtre de sortie de lumière, dans lequel la chambre est définie par un fond (21) et au moins une paroi environnante (22, 23, 24, 25), et dans lequel une surface (4a) du fond (21) de la chambre est réfléchissante, et
au moins une source de lumière (6, 8) agencée au niveau du fond (21) de la chambre (2) et adaptée pour émettre de la lumière vers la fenêtre de sortie de lumière,
dans lequel la fenêtre de sortie de lumière de la chambre comprend un élément luminescent (10), et
dans lequel l'agencement optique comprend en outre un élément de diffraction (12, 13) agencé entre la source de lumière (6, 8) et la fenêtre de sortie de lumière, de sorte que la lumière émise depuis la source de lumière vers la couche de fenêtre de sortie de lumière soit adaptée pour traverser l'élément de diffraction (12) ; **caractérisé en ce que** l'élément luminescent (10) comprend de multiples couches de phosphore (10a-c) ou de multiples segments de phosphore (10d-f).

2. Agencement optique selon la revendication 1, dans lequel l'agencement optique comprend une pluralité de sources de lumière (6).

3. Agencement optique selon la revendication 2, dans lequel au moins deux sources de lumière partagent un élément de diffraction commun (13).

4. Agencement optique selon la revendication 1, dans lequel ladite paroi environnante (22, 23, 24, 25) de la chambre (2) est réfléchissante.

5. Agencement optique selon la revendication 1, dans lequel ladite au moins une source de lumière (6, 8) et l'élément de diffraction (12, 13) sont agencés au niveau d'une partie du fond (21) de la chambre (2) près de ladite paroi environnante.

6. Agencement optique selon la revendication 1, dans lequel ledit élément de diffraction (12, 13) est attaché à ladite source de lumière (6, 8).

7. Agencement optique selon la revendication 1, dans lequel ledit élément de diffraction (12, 13) est agencé à une distance d1 de ladite source de lumière (6, 8).

8. Agencement optique selon la revendication 1, dans lequel ledit élément de diffraction (12, 13) est agencé à une distance d2 dudit élément luminescent (10).

9. Agencement optique selon la revendication 1, dans lequel ladite source de lumière (6, 8) est une LED (6) ou une diode laser (8).

10. Agencement optique selon la revendication 1, dans lequel ladite chambre (2) est remplie d'un fluide ou d'un solide.

11. Agencement optique selon la revendication 1, dans lequel ledit élément luminescent (10) est transparent.

12. Agencement optique selon la revendication 1, dans lequel ledit élément luminescent (10) est dispersant.

13. Luminaire comprenant un agencement optique selon l'une quelconque des revendications 1 à 12.
